# EUROPÄISCHE PATENTSCHRIFT

(11) **EP 2 530 526 B1**
(45) Veröffentlichungstag und Bekanntmachung des Hinweises auf die Patenterteilung: **23.03.2016**
(21) Anmeldenummer: 12170047.0
(22) Anmeldetag: 30.05.2012
(51) Int. Cl.: G03F 7/16

(54) **Vorrichtung zum Drehbelacken von Substraten**
Device for coating substrates in a rotating manner
Dispositif de vernissage rotatif de substrats

(30) Priorität: 01.06.2011 DE 102011050824; 01.06.2011 DE 202011050332 U
(43) Veröffentlichungstag der Anmeldung: 05.12.2012
(73) Patentinhaber: Solar-Semi GmbH, 78315 Radolfzell (DE)
(72) Erfinder: Muffler, Pirmin, 78359 Nenzingen (DE)
(74) Vertreter: Patentanwälte und Rechtsanwalt Weiß, Arat & Partner mbB

(56) Entgegenhaltungen:
- WO-A2-2005/103825
- US-B1- 6 207 231

## Beschreibung

Die Erfindung betrifft eine Vorrichtung zum Drehbelacken von Substraten nach dem Oberbegriff des Anspruchs 1, sowie einer Verwendung nach Anspruch 7 und eines Verfahrens nach Anspruch 8.

### Stand der Technik

Aus dem Stand der Technik sind vielfältige unterschiedliche Vorrichtungen zum Drehbelacken von Substraten bekannt. Insbesondere in der Halbleitertechnik sind Dreh- bzw Spinbelacker zum Aufbringen von Fotolack auf Substrate bekannt. Diese Dreh- bzw. Spinbelacker werden auch als "Coater" bezeichnet. Als Substrate dienen Wafer oder Glasscheiben od. dgl.. In diesem Zusammenhang wird insbesondere auf die EP 1 743 220 A1 verwiesen.

In diesem Zusammenhang wird auf die US 6,207,231 B1 und die WO 2005/103825 A2 hingewiesen, welche ebenfalls Spinbelacker nach dem Stand der Technik offenbaren, wis sie oben beschrieben wurden.

Die im Stand der Technik beschriebene Vorrichtung zum Drehbelacken von Substraten beschreibt einen Spinbelacker, welcher einen drehbaren Substratteller zur horizontalen Auflage eines Substrats und eine Abdeckeinheit zum Abdecken des Substrats während eines Verteilvorgangs des flüssigen Mediums durch Drehen des Substrathalters aufweist, wobei der Substrathalter mit der Abdeckeinheit dicht zusammenfügbar ist. Der Substrathalter weist umfänglich angeordnete Durchgangslöcher auf, über welche der aus der Abdeckeinheit und dem Substrathalter gebildete Belackungsinnenraum nach wie vor nach aussen in Verbindung steht, wobei im Abstand zu den umfänglich angeordneten Durchgangslöchern ein radial gegenüberliegender Wandabschnitt vorgesehen ist, wobei während des Drehenbelackens die Durchgangslöcher zum Wandabschnitt eine Relativbewegung ausführen.

In der aus dem Stand der Technik beschriebenen Vorrichtung ist aber kein voneinander getrennter Drehteller und Substratteller vorhanden. Vielmehr ist der dort als Substrathalter gekennzeichnete Bereich einstückig ausgeformt. Zwischenzeitlich hat sich aber allgemein durchgesetzt, dass es einer zweistückigen Aufgliederung des Substrathalters aus dem Stand der Technik in einen Substratteller und einen Drehteller bedarf, um auf unterschiedliche Anforderung im Herstellungsprozess reagieren zu können. Auf diese Weise kann beispielsweise der Substratteller ausgewechselt werden, was wiederum dazu führt, dass ein und dieselbe Vorrichtung für verschiedene Grössen von herzustellenden Substraten geeignet ist. Durch die Unterteilung des Substrathalters aus dem Stand der Technik in einen Substratteller und einen Drehteller kam es aber zu unerwünschten Zug- und Verwirbelungserscherscheinungen, weil unterhalb des Drehtellers vorhandene Luft mit entsprechend unerwünschten Partikeln durch den Unterdruck im Inneren des Belackungsinnenraums zwischen dem Drehteller und dem Substratteller in den Belackungsinnenraum gezogen wurde. Diese unerwünschte Luft aus dem unteren Bereich des Drehtellers gelangte in den Zwischenraum zwischen den Drehteller und den Substratteller, beispielsweise durch eine Rotationswelle, welche den Drehteller, wie auch den Substratteller antreibt. Neben der Rotationswelle führen auch sogenannte Rastelemente, welche die richtige Verrastung des Substrattellers auf dem Drehteller bewirken sollen dazu, dass unerwünschte Partikel durch den Zwischenraum zwischen Drehteller und Substratteller in den Belackungsinnenraum gezogen wurden. Bei abdichtendem Verschluss zwischen Drehteller und Abdeckeinheit führen die Durchgangsöffnungen dazu, dass sich zwischen dem Drehteller und dem Substratteller ein Durchlass öffnet, weil sich der Substratteller in sehr geringem Umfang vom Drehteller ablöst. Durch diese Ablösung wiederum werden die unerwünschten Partikel, welche sich unterhalb des Drehtellers befinden, durch den Durchlass der Rotationswelle oder die Partikel, welche sich in den Rastelemente-Bereichen festsetzen, in den Belackungsinnenraum gezogen. Diese Partikel wiederum setzen sich auf dem flüssigen Medium ab und beeinträchtigen die Qualität der entstehenden Produkte. Ausserdem kommt es aufgrund der unerwünschten Zugerscheinungen zu einem nicht vorhersehbaren Umleiten der Luftströme, welche dann nicht mehr in die Durchgangsöffnungen geleitet werden, sondern unkoordiniert im Belackungsinnenraum verteilt werden. Ausserdem kommt es bei der im Stand der Technik beschriebenen Anordnung mit unterteiltem Substratteller und Drehteller zu dem nachteiligen Umstand, dass durch die unerwünscht eingebrachte Luft auch der aus dem Stand der Technik bekannte Deckel durch das im Belackungsinnenraum entstehende unerwünschte Luftpolster leicht angehoben wird, was zu zusätzlichen Verwirbelungen führt.

### Aufgabe der Erfindung

Die Aufgabe der Erfindung liegt darin, eine Vorrichtung zum Drehbelacken von Substraten zur Verfügung zu stellen, welche die aus dem Stand der Technik bekannten Nachteile abstellt. In diesem Zusammenhang soll insbesondere vermieden werden, dass es zu ungewollten Zugerscheinungen im Belackungsinnenraum kommt. Dies wiederum soll die Qualität und den Kostenaufwand der Substratherstellung positiv beeinflussen. Für Serien-Herstellungsprozesse mit entsprechend grosser Produktionsrate ist es besonders wichtig, dass das flüssige Medium, beispielsweise ein Photolack möglichst homogen auf das Substrat aufgebracht wird. Dies soll unabhängig von der Grösse bzw. dem Durchmesser des Substrats geschehen. Aus dem Stand der Technik sind auch entsprechende Dreh- bzw. Spinbelacker bekannt, bei denen eine Abdeckeinheit eingesetzt wird. Diese Abdeckeinheit senkt sich über das zu belackende Substrat. Damit soll ein Lösungsmittelpolster auf dem Substrat bzw. dem aufgebrachten flüssigen Medium erzeugt werden, was beim Spinnvorgang zu einer besseren Verteilung der Lackschicht führt. Ohne eine Abdeckung würde eine unerwünschte "Abtrocknung" des flüssigen Mediums vonstatten gehen, was allerdings die Qualität der hergestellten Produkte negativ beeinflusst.

### Lösung der Aufgabe

Zur Lösung der Aufgabe führt der kennzeichnende Teil des Anspruchs 1 sowie der Verwendung nach Anspruch 7 und dem Verfahren nach Anspruch 8.

Die erfindungsgemässe Vorrichtung zum Drehbelacken von Substraten weist einen Drehteller auf. Dieser Drehteller stellt eine Schalenkonstruktion dar, Grösse, Form, Material oder Ausgestaltung des Drehtellers sind dem zuständigen Fachmann überlassen. Letztendlich sind die Drehteller als eine Art Schale ausgebildet. Diese Schale wirkt mit einer Abdeckeinheit zusammen. Die Abdeckeinheit ist geeignet zum Abdecken eines Substrats während eines Verteilvorgangs des flüssigen Mediums durch Drehen des Drehtellers. Als Substrat kommen alle in der Halbleitertechnik bekannten und bei Coatern eingesetzten Substrate in Betracht. Lediglich beispielhaft sind hier Wafer oder Glasscheiben erwähnt. Als flüssiges Medium kommen typischerweise Polymerlösungen in Betracht. In der Regel handelt es sich dabei um sogenannte Photolacke, welche auch als photoresist bezeichnet werden. Sie setzen sich aus einem Bindemittel, einem Sensibilisator und einem Lösemittel zusammen. Der Anteil des Bindemittels beträgt hierbei ca. 20%. Als Bindemittel werden häufig Novolacke eingesetzt. Dabei handelt es sich um Phenolharze, wie Kunstharz oder Kunststoff, welche in erster Linie die thermischen Eigenschaften des Lackes bestimmen. Der Sensibilisator bildet einen Anteil von ca. 10% an der gesamten chemischen Zusammensetzung. Der Sensibilisator bestimmt die Lichtempfindlichkeit des Lackes. Sensibilisatoren setzen sich aus Molekülen zusammen, die bei einer Belichtung mit energiereicher Strahlung und die Löslichkeit des Lackes verändern. Im Positivlack entsteht aus dem Sensibilisator durch die Belichtung Karbonsäure. Damit der Lack nicht durch das Licht in den Fertigungshallen belichtet wird, finden die Phototechnikprozesse unter Gelblicht statt, gegen das der Lack unempfindlich ist. Das Lösemittel hat einen Anteil von 70% an der gesamten chemischen Zusammensetzung. Die Lösemittel bestimmen die Viskosität des Lackes. Durch das Verdampfen der Lösemittel auf einer Heizplatte wird der Lack stabilisiert und resistent für nachfolgende Prozesse. In der Regel haben die von Herstellern gelieferten Lacke eine definierte Oberflächenspannung und Dichte, sowie einen bestimmten Feststoffgehalt und eine bestimmte Viskosität. Somit ist bei der Belackung der Chipfertigung die erzielte Photolackdicke hauptsächlich von der Drehzahl der Belackungsanlage abhängig. In diesem Zusammenhang wird auch darauf hingewiesen, dass es zu großen Schwankungen in den angegebenen Prozentzahlen der einzelnen Bestandteile kommen kann. Dies hängt in erster Linie von den an die entsprechenden Lacke gestellten Anforderungen ab.

Der erfindungsgemässe Drehteller weist umfänglich angeordnete Durchgangslöcher auf. Diese Durchgangslöcher führen zu einem sogenannten Strahlpumpeneffekt. Dies wird vorteilhaft zur Abführung von überschüssigem flüssigen Medium durch die Durchgangslöcher genutzt.

Das besonders bevorzugte Ausführungsbeispiel einer erfindungsgemässen Vorrichtung ist derart gestaltet, dass der Drehteller auf der dem Substrat gegenüberliegenden Seite atmosphärisch abgedichtet ist. Dies bedeutet, dass der Drehteller zu dem Substratteller hin abgedichtet ist. Dies kann beispielsweise in der Art geschehen, dass eine Dichtung zwischen dem Drehteller und dem Substratsteller angeordnet ist. Diese Dichtung ist geeignet, den Substratteller gegenüber dem Drehteller atmosphärisch abzudichten. In der Regel handelt es sich hierbei um eine O-Dichtung. In einem anderen Ausführungsbeispiel kann die Abdichtung aber auch in der Weise erfolgen, dass der Drehteller aus selbstdichtendem Material besteht. Ein anderes mögliches Ausführungsbeispiel kann auch der Art ausgestaltet sein, dass die Dichtung als Teil des Drehtellers oder des Substrattellers ausgeformt ist. Letztendlich ist hier insbesondere von Belang, dass der Drehteller auf der dem Substrat gegenüberliegenden Seite atmosphärisch abgedichtet ist. Die Ausführung der einzelnen technischen Merkmale obliegt dem zuständigen Fachmann. Durch diese Abdichtung wird vorteilhaft erreicht, dass die atmosphärischen Zustände innerhalb des Belackungsinnenraumes wieder nach gewünschten Parametern funktionieren. Überschüssiges flüssiges Medium wird dann entsprechend durch die vorgesehenen Durchgangsöffnungen abgeleitet. Die Qualität der Durchgangsöffnungen kann in einer Serienherstellung gewährleistet werden.

Eine erfindungsgemässe Vorrichtung weist eine Rotationswelle auf. Diese Rotationswelle durchgreift den Drehteller und mündet in den Substratteller. Ein Durchgreifen des Substrattellers durch die Rotationswelle ist ebenfalls vorgesehen. Die Rotationswelle dient der rotierenden Bewegung von Drehteller und Substratteller. In diesem Zusammenhang wird die Rotationswelle beispielsweise durch eine Schraube oder eine Mutter oder ein anderes Verbindungselement mit dem Substratsteller verbunden. Bei dieser Verbindung wird der Drehteller und der Substratsteller aneinander gedrückt. Außerdem wird an den Durchlass welcher durch die Rotationswelle in den Belackungsinnenraum ein Unterdruck angelegt, so dass das Substrat, welches auf dem Substratsteller aufgelegt wird an dem Substratsteller angesogen wird. Um einen wirksamen Unterdruck erzeugen zu können wird in einem Ausführungsbeispiel eine gesonderte Abdichtung zwischen dem Substratsteller und dem Drehteller angebracht.. Durch das Ansaugen des Substrats wird auch vorteilhaft verhindert, dass das Substrat, welches oft nur wenige Gramm wiegt durch die Rotation des Substratstellers weg geschleudert wird. Anschließend wird durch die Drehbewegung vorteilhaft das flüssige Medium in gewünschter Weise auf dem Substrat verteilt. Daneben wird durch diese Anordnung vorteilhaft erreicht, dass die Abdichtung des Drehtellers auf der dem Substrat gegenüberliegenden Seite durch das Ansaugen des Substrats und der Befestigung der Rotationswelle mit dem Substratteller zusätzlich unterstützt wird.

Die Rotationswelle wird durch einen Antrieb angetrieben. Bei dem Antrieb handelt es sich regelmässig um einen Elektroantrieb. Ebenso sind aber auch andere Arten von Antrieben denkbar. Die Auswahl einer entsprechenden Antriebsform soll dem Fachmann vorbehalten bleiben. Vorteilhaft an dem Antrieb ist der Umstand, dass die Geschwindigkeit der Rotation des Drehtellers und/oder Substrattellers stufenlos in gewünschter Weise eingestellt werden kann.

Ein bevorzugtes Ausführungsbeispiel einer erfindungsgemässen Vorrichtung weist ausserdem ein Rastelement auf. Diese Rastelemente dienen dazu, dass der Substratteller und der Drehteller zueinander platziert werden können. Diese bedeutet im Einzelnen, dass der Nutzer beim Einsetzen des Substrattellers in den Drehteller die optimale Position automatisch durch Zusammenspiel von Rastelementen, welche beispielsweise auf dem Drehteller angeordnet sind und Ausnehmungen, welche dann auf dem Substratteller ausgeformt sind, erhält . Die Anordnung des Rastelements kann aber auch auf dem Substratteller erfolgt sein. Entsprechend ist dann die Ausnehmung auf dem Drehteller anzubringen. Vorteilhaft ist hierbei, dass ein entsprechender Nutzer immer durch Einrasten des Substrattellers auf dem Drehteller die optimale Position der beiden Teller zueinander erhält.

Weiterhin weist eine erfindungsgemässe Vorrichtung bevorzugt einen Lifter auf. Dieser Lifter ist derart gestaltet, dass er stabförmig unterhalb des Drehtellers angeordnet ist. Er wird dann durch eine Hebevorrichtung durch den Drehteller und den Substratteller durchgeführt. Er dient dazu, das Substrat vom Substratteller an- bzw. abzuheben. Nachdem das Substrat dann mit dem aufgebrachten flüssigen Medium aus der Vorrichtung entnommen ist, wird der Lifter wieder zurück in seine ursprüngliche Position unterhalb des Drehtellers verfahren. Vorteilhaft ist hierbei, dass eine vollautomatisierte Fertigung erreicht wird, da nicht manuell ein entsprechend mit flüssigem Medium versehenes Substrat angehoben werden muss. Dadurch kommt es seltener zu Verschmelzungen an dem Substrat bzw. aufgebrachten flüssigen Medium.

Besonders bevorzugt ist die erfindungsgemässe Dichtung derart angebracht, dass der Lifter bzw. dessen Durchgriffsöffnungen und/oder das Rastelement und/oder die Rotationswelle umfasst sind. Dies bedeutet im Einzelnen, dass im Zwischenbereich zwischen Drehteller und Substratteller keine Verschmutzungen aus dem Lifter und/oder dem Rastelement und/oder der Rotationswelle in den Belackungsinnenraum gelangen können. Die Dichtung ist bevorzugt an dem Drehteller angebracht. Sie kann aber auch an dem Substratteller angebracht sein. Letztendlich ist besonders zu beachten, dass die Dichtung bei Anbringung an dem Substratteller am besten möglichst von der Mitte weg am äusseren Rand des Kreisradius angebracht sein sollte. Sollte die Dichtung auf dem Drehteller angebracht sein, so ist zumindest darauf zu achten, dass der Lifter und/oder das Rastelement und/oder die Rotationswelle durch die Dichtung zumindest derart umfasst sind, dass keines dieser Elemente ausserhalb der Dichtung liegt. Dies würde wiederum dazu führen, dass verschmutzte Luft zwischen Drehteller und Substratteller in den Belackungsinnenraum gelangen könnte. Gerade dies soll aber verhindert werden. Vorteilhaft ist die Verbesserung der Qualität der hergestellten Erzeugnisse.

Vorzugsweise soll die Dichtung in Form eines O-Rings ausgestaltet sein, da ein solcher O-Ring gerade aus Kunststoff oder Gummi eine vibrationsaufnehmende Wirkung hätte. Eine solche vibrationsaufnehmende Wirkung ist bei den Rotationsgeschwindigkeiten ebenfalls zur Erreichung einer guten Qualität der hergestellten Wafer etc von Vorteil.

Weiterhin soll bevorzugt eine Verwendung einer Vorrichtung derart genutzt werden, dass sie zur Halbleiterherstellung eingesetzt wird. Gerade bei der Serienfertigung weist die erfindungsgemässe Vorrichtung grosse Vorteile auf.

Bei einem Verfahren zum Betreiben einer erfindungsgemässen Vorrichtung soll die abdichtende Verbindung zwischen der Abdeckeinheit und dem Drehteller in den letzten 2% bis 25% oder bevorzugter 5% bis 15%, noch bevorzugter 10% der Gesamtherstellungsdauer völlig abgedichtet werden. Die Gesamtherstellungsdauer bedeutet hierbei, die Dauer, welche notwendig ist, von der Einbringung des Substrats und dem Aufbringen des flüssigen Mediums, bis zum Anheben des Substrats mit aufgebrachtem flüssigem Medium durch den Lifter. Hier ist vorteilhaft herauszuheben, dass eine allmählich während des Verfahrens hergestellte Abdichtung zu positiven Veränderungen der Fliesseigenschaften des flüssigen Mediums führt. Es kommt zu einer besseren Verteilung auf dem Substrat und einer anschliessenden besseren Ableitung von der Kante des Substrats in die vorgesehenen Durchgangsöffnungen.

### Figurenbeschreibung

Weitere Vorteile, Merkmale und Einzelheiten der Erfindung ergeben sich aus der nachfolgenden Beschreibung bevorzugter Ausführungsbeispiele sowie anhand der Zeichnung; diese zeigt
- Figur 1: eine Draufsicht auf eine erfindungsgemässe Vorrichtung;
- Figur 2: eine geschnittene Seitenansicht der Ansicht nach Figur 1;
- Figur 3: eine vergrösserte Teilansicht eines Bereichs aus der Figur 2.

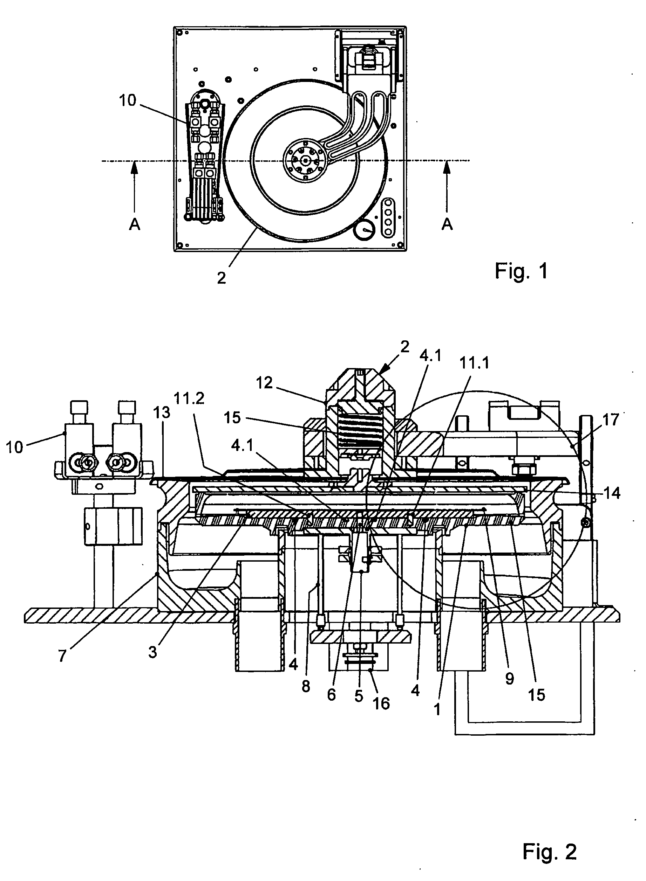

In Figur 1 ist eine Draufsicht auf eine erfindungsgemässe Vorrichtung gezeigt. Dort ist eine Abdeckeinheit 2 zu erkennen. Die Abdeckeinheit 2 ist in Figur 1 auf einen nicht sichtbaren Drehteller abgesenkt. Ausserdem findet sich in Figur 1 eine Belackereinheit 10. Diese Belackereinheit 10 wird bei geöffneter Abdeckeinheit über den in Figur 1 nicht gezeigten Drehteller geschwenkt, um entsprechend ein flüssiges Medium auf ein ebenfalls nicht gezeigtes Substrat 9 aufzubringen. Weiterhin ist in der Figur 1 eine Schnittlinie A-A zu erkennen.

Figur 2 zeigt eine leicht vergrösserte geschnittene Seitenansicht an der Schnittlinie A-A aus Figur 1. Dort ist wiederum die Abdeckeinheit 2 gezeigt, wie sie auf den Drehteller 1 abgesenkt ist. Die Abdeckeinheit 2 besteht aus einem Kopfteil 12, einer Ballenabdeckung 13 und einer Drehtellerabdeckung 14. Im Kopfteil 12 der Abdeckeinheit ist ein Federelement 15 zu erkennen. Dieses Federelement 15 bewirkt, dass bei der rotierenden Bewegung des Drehtellers 3 die Wannenabdeckung 13 und die Drehtellerabdeckung 14 mit entsprechendem Druck auf den Drehteller 3 bzw. die Wanne 7 zum Aufliegen kommen. Ausserdem werden durch Fliehkräfte entstehende Unrundheiten durch das Federelement 15 aufgenommen, so dass eine sich selbst austarierende Wirkung erzielt wird.

In Figur 2 ist ausserdem ein Substratteller 3 gezeigt. Dieser Substratteller 3 ist zwischen dem Drehteller 1 und dem Substrat 9 angeordnet. Unterhalb des Drehtellers 1 ist ein Antrieb 5 gezeigt, welcher über eine Rotationswelle den Drehteller 1 und den Substratteller 3 rotierend bewegt. Durch die rotierende Bewegung des Substrattellers 3 wird auch erreicht, dass das Substrat 9 rotiert. Die Drehwelle 6 ragt durch den Drehteller 1 hindurch und in den Substratteller 3 hinein. Ausserdem ist in Figur 2 ein Rastelement 11.1, 11.2 zu erkennen. Dieses Rastelement 11.1, 11.2 ist derart gestaltet, dass es eigenständig in nicht näher beschriebene Ausnehmungen des Drehtellers 1 und des Substrattellers 3 hineinragt. Es kann aber auch derart gestaltet sein, dass das Rastelement 11.1, 11.2 als Teil des Drehtellers 1 bzw. Substrattellers 3 ausgebildet ist. In einem solchen Fall wäre dann eine entsprechende Ausnehmung im Drehteller 1 oder im Substratteller 3 vorzusehen, so dass das Rastelement entsprechend eingreifen kann. Das Rastelement 11.1, 11.2 dient der einfachen und genauen Fixierung und Platzierung des Substrattellers 3 auf dem Drehteller 1. Ausserdem ist unterhalb des Drehtellers 1 ein Lifter 8 gezeigt. Dieser Lifter 8 ist stabförmig derart gestaltet, dass er durch einen Lifterantrieb 16 durch den Drehteller 1 und den Substratteller 2 hindurchgreift und das Substrat 9 vom Substratteller 3 abhebt. Zwischen dem Drehteller 1 und dem Substratteller 3 ist ausserdem eine Dichtung 4 in Form eines O-Rings gezeigt. Diese Dichtung 4 ist derart angeordnet, dass sie das Rastelement 11.1, 11.2 und die Rotationswelle 6 umgreift. In dem bevorzugten Ausführungsbeispiel ist ausserdem die Dichtung 4.1 gezeigt, welche lediglich die Rotationswelle 6 umgreift und verhindert, dass Partikel aus dem Bereich unterhalb des Drehtellers 1, also im Bereich des Antriebs 5 durch den nicht näher beschriebenen Gang der Rotationswelle 6 in den Zwischenbereich zwischen den Drehteller 3 und den Substratteller 1 gelangen können. Hierbei handelt es sich lediglich um eines von verschiedenen Ausführungsbeispielen.

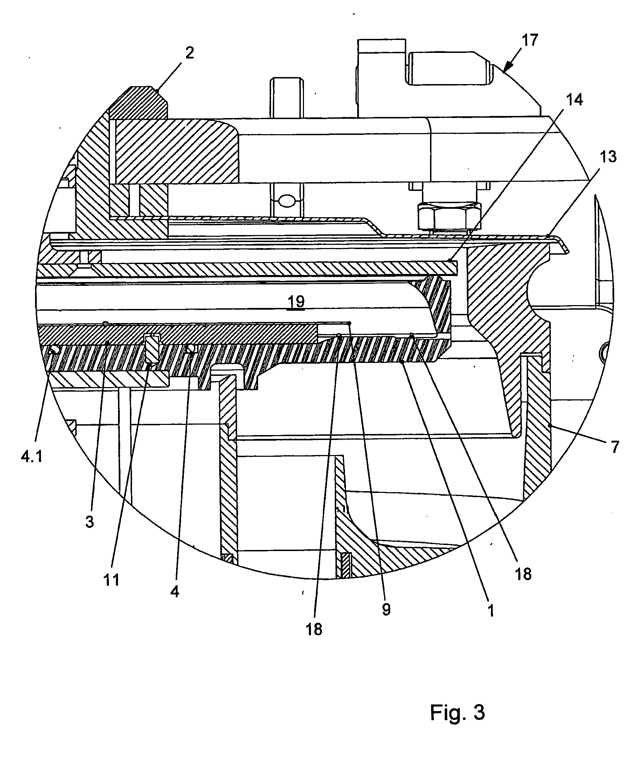

Weiter ist in Figur 3 eine vergrösserte Teilansicht der Figur 2 namentlich des Ausschnitts 17 , nochmals vergrössert kenntlich gemacht. Dort ist insbesondere gut zu erkennen, wie in dem Umfang des Drehtellers 1 verschiedene Durchgangsöffnungen 18 angeformt sind. Ausserdem ist nochmals gezeigt, wie die Dichtung 4 den Bereich der Rastelemente kreisförmig umfasst und die Dichtung 4.1, die in Figur 3 nicht mehr gezeigte Rotationswelle 6 umgreift, um zu verhindern, dass zwischen dem Drehteller 1 und dem Substratteller 3 Partikel in den Belackungsinnenraum 19 gelangen.

**Bezugszeichenliste**

| | | | | | |
|---|---|---|---|---|---|
| 1 | Drehteller | 34 | | 67 | |
| 2 | Abdeckeinheit | 35 | | 68 | |
| 3 | Substratteller | 36 | | 69 | |
| 4 | Dichtung | 37 | | 70 | |
| 5 | Antrieb | 38 | | 71 | |
| 6 | Rotationswelle | 39 | | 72 | |
| 7 | Wanne | 40 | | 73 | |
| 8 | Lifter | 41 | | 74 | |
| 9 | Substrat | 42 | | 75 | |
| 10 | Belacker-Einheit | 43 | | 76 | |
| 11 | Rastelement | 44 | | 77 | |
| 12 | Kopfteil | 45 | | 78 | |
| 13 | Wannenabdeckung | 46 | | 79 | |
| 14 | Drehtellerabdeckung | 47 | | | |
| 15 | Federelement | 48 | | | |
| 16 | Lifterantrieb | 49 | | | |
| 17 | Ausschnitt | 50 | | | |
| 18 | Durchgangsöffnung | 51 | | | |
| 19 | Belackungsinnenraum | 52 | | | |
| 20 | | 53 | | | |
| 21 | | 54 | | | |
| 22 | | 55 | | | |
| 23 | | 56 | | | |
| 24 | | 57 | | | |
| 25 | | 58 | | | |
| 26 | | 59 | | | |
| 27 | | 60 | | | |
| 28 | | 61 | | | |
| 29 | | 62 | | | |
| 30 | | 63 | | | |
| 31 | | 64 | | | |
| 32 | | 65 | | | |
| 33 | | 66 | | | |

## Patentansprüche

1. Vorrichtung zum Drehbelacken von Substraten mit flüssigen Medien mit einem Drehteller (1) und einer Abdeckeinheit (2) zum Abdecken des Substrats während eines Verteilvorgangs des flüssigen Mediums durch Drehen des Drehtellers (1), wobei der Drehteller (1) mit der Abdeckeinheit (2) dicht zusammenfügbar ist, wobei jedoch umfänglich angeordnete Durchgangslöcher vorgesehen sind, über welche der aus Abdeckeinheit (2) und Drehteller (1) gebildete Belackungsinnenraum nach aussen in Verbindung steht, wobei an den Drehteller (1) ein Substratteller (3) anliegt,
**dadurch gekennzeichnet,**
**dass** der Drehteller (1) auf der dem Substrat gegenüberliegenden Seite atmosphärisch abgedichtet ist.

2. Vorrichtung nach Anspruch 1, **dadurch gekennzeichnet, dass** der Drehteller (1) und der Substratteller (3) durch eine Rotationswelle (6) angetrieben sind.

3. Vorrichtung nach Anspruch 2, **dadurch gekennzeichnet, dass** die Rotationswelle (6) einen Antrieb (5) aufweist.

4. Vorrichtung nach einem der Ansprüche 1 bis 3, **dadurch gekennzeichnet, dass** der Drehteller (1) und der Substratteller (3) zueinander durch ein Rastelement (11) platziert sind, wobei der Substratteller (3) abnehmbar ist.

5. Vorrichtung nach einem der Ansprüche 1 bis 4, **dadurch gekennzeichnet, dass** ein Lifter (8) vorhanden ist, welcher durch den Drehteller (1) und den Substratteller (3) durchgreifbar angeordnet ist, um ein Substrat (9) von dem Substratteller (3) zu heben.

6. Vorrichtung nach Anspruch 5, **dadurch gekennzeichnet, dass** der Lifter (8) und/oder das Rastelement (11) und/oder die Rotationswelle (6) durch die Dichtung (4) umfasst sind, sodass der Substratteller (3) gegenüber dem Drehteller (1) atmosphärisch abgedichtet ist.

7. Verwendung einer Vorrichtung nach einem der Ansprüche 1 bis 6, kennzeichnend zur Herstellung eines Substrats, geeignet zur Halbleiterherstellung.

8. Verfahren zum Betreiben einer Vorrichtung nach einem der Ansprüche 1 bis 6, **dadurch gekennzeichnet, dass** die abdichtende Verbindung zwischen der Abdeckeinheit (2) und dem Drehteller (1) in den letzten 2% bis 25% oder 5% bis 15% der Gesamtherstellungsdauer des Substrats (9) vor Abschluss der Herstellung völlig abgedichtet wird.

## Claims

1. A device for rotary coating of substrates with liquid media, with a rotary plate (1) and a covering unit (2) for covering the substrate during a distribution operation for the liquid medium by turning the rotary plate (1), wherein the rotary plate (1) can be assembled tightly with the covering unit (2), but wherein peripherally arranged through-holes are provided via which the coating interior formed of the covering unit (2) and the rotary plate (1) is connected to the outside, wherein a substrate plate (3) lies against the rotary plate (1),
**characterised in that**
the rotary plate (1) is sealed off atmospherically on the side opposite the substrate.

2. A device according to Claim 1, **characterised in that** the rotary plate (1) and the substrate plate (3) are driven by a rotating shaft (6).

3. A device according to Claim 2, **characterised in that** the rotating shaft (6) has a drive (5).

4. A device according to one of Claims 1 to 3, **characterised in that** the rotary plate (1) and the substrate plate (3) are positioned relative to each other by a latching element (11), the substrate plate (3) being removable.

5. A device according to one of Claims 1 to 4, **characterised in that** a lifter (8) is present which is arranged to be able to engage through the rotary plate (1) and the substrate plate (3) in order to lift a substrate (9) from the substrate plate (3).

6. A device according to Claim 5, **characterised in that** the lifter (8) and/or the latching element (11) and/or the rotating shaft (6) are encompassed by the seal (4), so that the substrate plate (3) is sealed off atmospherically relative to the rotary plate (1).

7. Use of a device according to one of Claims 1 to 6, characterising for the production of a substrate, suitable for producing semiconductors.

8. A method for operating a device according to one of Claims 1 to 6, **characterised in that** the sealing connection between the covering unit (2) and the rotary plate (1) is completely sealed off in the last 2% to 25% or 5% to 15% of the entire duration of production of the substrate (9) before the production is concluded.

## Revendications

1. Dispositif de vernissage rotatif de substrats à l'aide de substances liquides, avec un plateau rotatif (1) et une unité de recouvrement (2) destinée à recouvrir le substrat au cours d'un processus de répartition de la substance liquide par rotation du plateau rotatif (1), le plateau rotatif (1) pouvant être assemblé de manière étanche avec l'unité de recouvrement (2), des trous de passage disposés sur le pourtour étant toutefois prévus, par lesquels l'espace de vernissage intérieur formé par l'unité de recouvrement (2) et le plateau rotatif (1) est en communication avec l'extérieur, contre le plateau rotatif (1) venant en applique un plateau de substrat (3),
**caractérisé par le fait**
**que** le plateau rotatif (1) est étanche à l'atmosphère du côté opposé au substrat.

2. Dispositif selon la revendication 1, **caractérisé par le fait que** le plateau rotatif (1) et le plateau de substrat (3) sont entraînés par un arbre rotatif (6).

3. Dispositif selon la revendication 2, **caractérisé par le fait que** l'arbre rotatif (6) présente un entraînement (5).

4. Dispositif selon l'une des revendications 1 à 3, **caractérisé par le fait que** le plateau rotatif (1) et le plateau de substrat (3) peuvent être placés l'un par rapport à l'autre par un élément d'encliquetage (11), le plateau de substrat (3) étant amovible.

5. Dispositif selon l'une des revendications 1 à 4, **caractérisé par le fait qu'**est présent un dispositif de levage (8) qui est disposé de manière à pouvoir passer par le plateau rotatif (1) et le plateau de substrat (3) pour soulever un substrat (9) du plateau de substrat (3).

6. Dispositif selon la revendication 5, **caractérisé par le fait que** le dispositif de levage (8) et/ou l'élément d'encliquetage (11) et/ou l'arbre rotatif (6) sont entourés par le joint d'étanchéité (4), de sorte que le plateau de substrat (3) soit rendu étanche à l'atmosphère par rapport au plateau rotatif (1).

7. Utilisation d'un dispositif selon l'une des revendications 1 à 6, caractéristique pour la production d'un substrat convenant pour la fabrication de semi-conducteurs.

8. Procédé pour faire fonctionner un dispositif selon l'une des revendications 1 à 6, **caractérisé par le fait que** la connexion étanche entre l'unité de recouvrement (2) et le plateau rotatif (1) est rendue entièrement étanche au cours des derniers 2% à 25% ou 5% à 15% de la durée de production totale du substrat (9) avant la fin de la production.
